# EUROPEAN PATENT APPLICATION

(11) **EP 3 163 728 A1**
(43) Date of publication of application: **03.05.2017**
(21) Application number: 15812308.3
(22) Date of filing: 14.01.2015
(51) Int. Cl.: H02M 1/00, B60L 3/00, B60L 9/24, H02M 7/12, H02M 7/48

(54) **POWER CONVERSION DEVICE AND VEHICLE CONTROL DEVICE**

(30) Priority: 26.06.2014 JP 2014131864
(71) Applicant: Kabushiki Kaisha Toshiba, Minato-ku Tokyo 105-8001 (JP)
(72) Inventor: UCHIDA Toshiyuki, Tokyo 105-8001 (JP); MAKINO Tomoyuki, Tokyo 105-8001 (JP)
(74) Representative: Awapatent AB
(86) International application number: PCT/JP2015/050849
(87) International publication number: WO 2015/198616

(57) **Abstract**

[Problem] To provide a power conversion device and a car control device capable of reducing the influence of heat generated in the devices.

[Solving Means] A power conversion device according to an embodiment includes a converter unit including a plurality of semiconductor switching devices and configured to convert AC power to DC power, and an inverter unit disposed to be adjacent to the converter unit in a railroad car running direction and including a plurality of semiconductor switching devices, the inverter unit being configured to convert the DC power outputted from the converter unit to AC power. First radiation fins are attached to a surface of a first heat receiving plate opposite to a surface on which the semiconductor switching devices are attached, and second radiation fins are attached to a surface of a second heat receiving plate opposite to a surface on which the semiconductor switching devices are attached. The first radiation fins and the second radiation fins facing one another are attached to the first heat receiving plate and the second heat receiving plate so that recessed portions of the first radiation fins and recessed portions the second radiation fins are aligned with one another.

## Description

### FIELD

Embodiments described herein relate generally to power conversion devices and car control devices mainly used for railroad cars.

### BACKGROUND

A railroad car generally uses DC power or AC power supplied from an overhead electric line to obtain electric power for driving its motor. The electric power for driving the motor is generated by a power conversion device installed under the railroad car floor.

The power conversion device performs a conversion operation between AC power and DC power by switching operations of semiconductor switching devices. Since heat is generated by the switching operations, the power conversion device includes a mechanism for dissipating the heat. For example, heat generated by a semiconductor switching device is conducted to a radiation fin via a heat receiving plate, and released from the radiation fin to the air for the cooling.

When heat is released from the radiation fin, a method in which the radiation fin is covered by a duct, and an air flow is caused in the duct by a blower for the cooling, or a method in which "travelling wind" caused by a railroad car when the railroad car is running is guided to hit a cooling fin, is generally used.
Patent Document 1: JP-A-2000-92819

### [Summary of the Invention]

### [Technical Problem]

As described above, the power conversion device includes a mechanism for releasing heat generated by the semiconductor switching devices. Since the downsizing of devices including power conversion devices have recently been accelerating, arrangements of respective devices in consideration of the influence of heat, and mechanisms for obtaining better heat dissipation efficiency are needed.

Under the circumstances, the object of the present invention is to provide a power conversion device and a car control device capable of reducing the influence of heat generated in the devices.

### [Solution to Problem]

A power conversion device according to an embodiment includes: a converter unit including a first heat receiving plate, and a plurality of semiconductor switching devices attached to the first heat receiving plate, the converter unit being configured to convert AC power to DC power; an inverter unit disposed to be adjacent to the converter unit in a railroad car running direction and including a second heat receiving plate, and a plurality of semiconductor switching devices attached to the second heat receiving plate, the inverter unit being configured to convert the DC power outputted from the converter unit to AC power; a plurality of first radiation fins attached to a surface of the first heat receiving plate opposite to a surface on which the semiconductor switching devices are attached; and a plurality of second radiation fins attached to a surface of the second heat receiving plate opposite to a surface on which the semiconductor switching devices are attached, the first radiation fins and the second radiation fins facing one another being attached to the first heat receiving plate and the second heat receiving plate so that recessed portions of the first radiation fins and recessed portions of the second radiation fins are aligned with one another.

### BRIEF DESCRIPTION OF THE DRAWINGS

[FIG. 1]

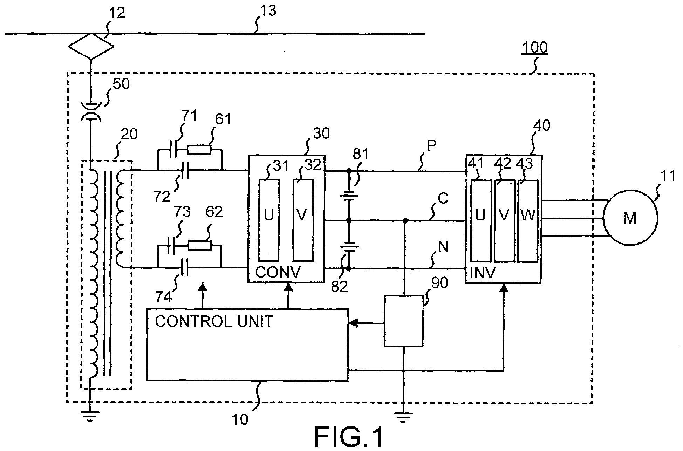

   FIG. 1 is a diagram showing a circuit configuration of a car control device according to a first embodiment.
[FIG. 2]

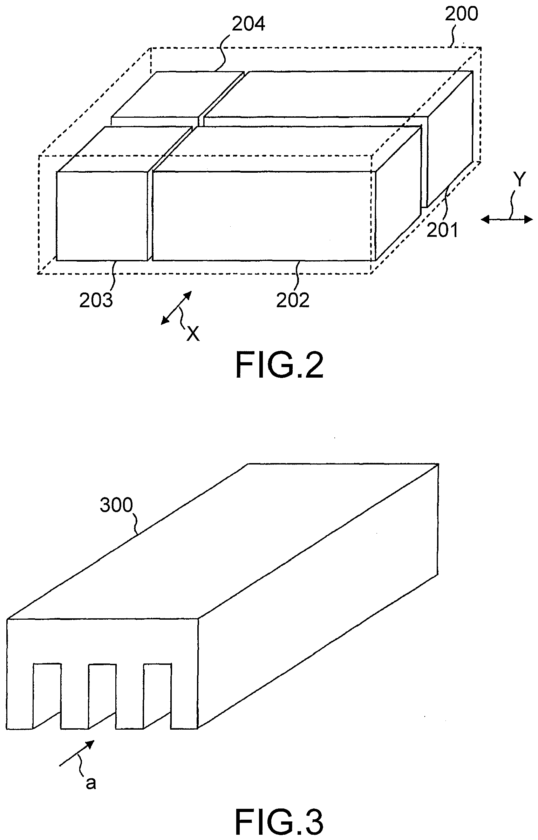

   FIG. 2 is a diagram showing a schematic device configuration of the car control device according to the first embodiment.
[FIG. 3]
   FIG. 3 is a diagram showing an example of a radiation fin shape according to the first embodiment.
[FIG. 4]

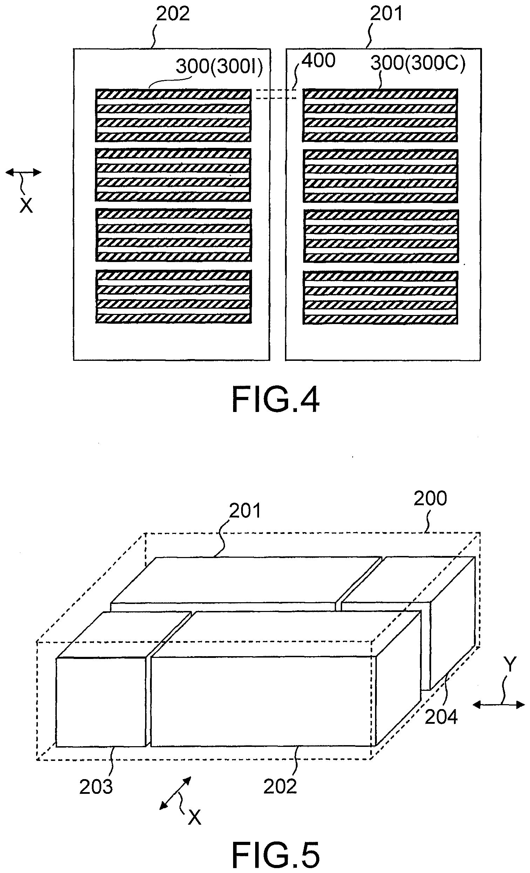

   FIG. 4 is a diagram showing an external appearance of a converter unit and an inverter unit to which the radiation fins according to the first embodiment are attached.
[FIG. 5]
   FIG. 5 is a diagram showing an example of a radiation fin shape according to a first modification of the first embodiment.
[FIG. 6]

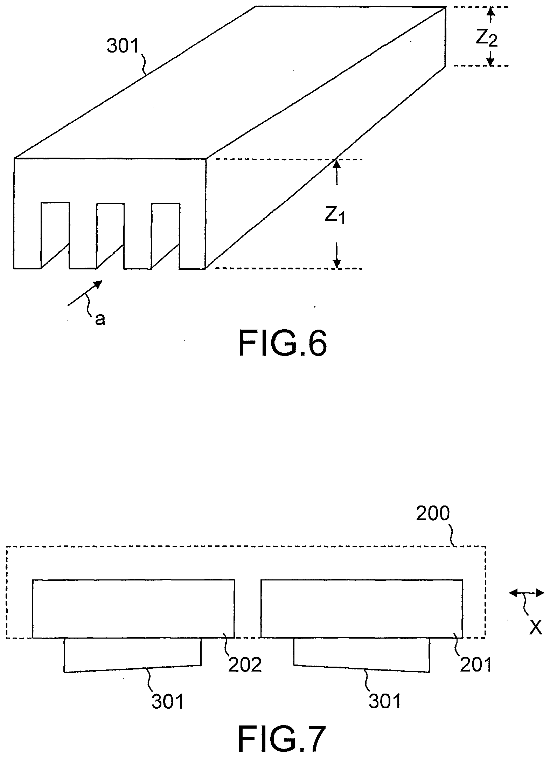

   FIG. 6 is a diagram showing an example of a radiation fin shape according to a second modification of the first embodiment.
[FIG. 7]
   FIG. 7 is a diagram showing an external appearance of the radiation fins according to the second modification when they are attached to the converter unit and the inverter unit.
[FIG. 8]

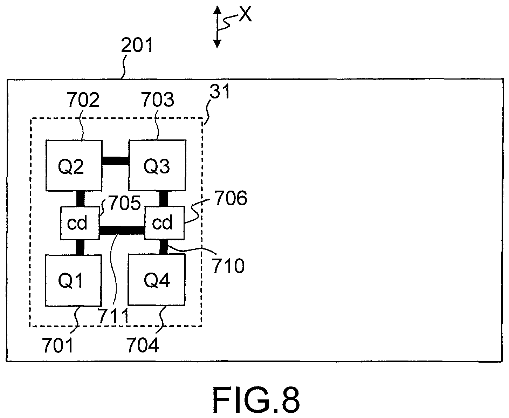

   FIG. 8 is a diagram showing the configuration of semiconductor devices according to a second embodiment.

### DETAILED DESCRIPTION

### (First Embodiment)

Hereinafter, a car control device according to a first embodiment will be described with reference to the accompanying drawings.

FIG. 1 shows a schematic configuration of a car control device 100 installed in a railroad car. The main function of the car control device 100 is to generate three-phase AC power for driving a motor 11 using AC power received from an overhead electric line 13 via a pantograph 12. The car control device 100 includes a control unit 10 configured to control respective devices included in the car control device 100, a transformer 20 configured to reduce in voltage the AC power received by a primary coil via the pantograph 12, a converter 30 configured to convert the AC power supplied from a secondary coil of the transformer 20 to DC power, and an inverter 40 configured to convert the DC power supplied from the converter to three-phase AC power.

A contactor 72 is disposed to one of two wiring lines between the secondary coil of the transformer 20 and the converter 30, and a contactor 74 is disposed to the other. Furthermore, a contactor 71 and a charge resistor 61, which are connected in series with each other, are connected in parallel with the contactor 72. A contactor 73 and a charge resistor 62, which are connected in series with each other, are connected in parallel with the contactor 74.

A positive electrode side wiring line P, a negative electrode side wiring line N, and a neutral point wiring line C are connected between the converter 30 and the inverter 40. A voltage-dividing capacitor 81 is disposed between the positive electrode side wiring line P and the neutral point wiring line C, and a voltage-dividing capacitor 82, which is connected in series with the voltage-dividing capacitor 81, is disposed between the neutral point wiring line C and the negative electrode side wiring line N. A current detector 90 configured to detect a ground-fault current is connected to the neutral point wiring line C.

The converter 30 includes a U-phase semiconductor device group 31 and a V-phase semiconductor device group 32 configured to convert the AC power supplied from the secondary coil of the transformer 20 to DC power, and the inverter 40 includes a U-phase semiconductor device group 41, a V-phase semiconductor device group 42, and a W-phase semiconductor device group 43 configured to convert the DC power supplied from the converter 30 to three-phase AC power.

When the car control device 100 including the aforementioned electric circuit is placed under the railroad car floor, the car control device 100 is divided into a converter unit 201 including the converter 30, an inverter unit 202 including the inverter 40, a control unit 203 including the control unit 10 configured to generate a gate command to be sent to the converter 30 and the inverter 40 and to control the opening and the closing of the contactors 71 to 74 and a circuit breaker 50, and a switch and sensor unit 204 including the contactors 71 to 74 and the current detector 90, and is housed in one housing 200, as shown in FIG. 2. Two arrows X and Y are shown in FIG. 2. The arrow X indicates directions along which the railroad car moves, and the arrow Y indicates lateral directions of the railroad car.

The converter unit 201, the inverter unit 202, the control unit 203, and the switch and sensor unit 204 only represent the grouping of the devices that are placed relatively close to each other due to their characteristics such as the wiring conditions and the thermal tolerance, but do not indicate the unitization of the devices. A power conversion device is configured by at least the converter unit 201, the inverter unit 202, and radiation fins that will be described below.

Furthermore, as shown in FIG. 2, the converter unit 201 and the inverter unit 202 are arranged along the directions X, in which the railroad car moves in this embodiment. In the directions Y, which are the lateral directions of the railroad car, the converter unit 201 and the inverter unit 202 are placed near one of the side surfaces of the railroad car. Since the converter unit 201 and the inverter unit 202 are placed near one of the side surfaces of the railroad car, the converter unit 201 and the inverter unit 202 may be put into and taken out through an opening formed on the side surface of the railroad car. Furthermore, the work efficiency of an inspection work or the like is considerably improved since the work may be performed on the same side surface of the railroad car.

As has been described with reference to FIG. 1, the converter unit 201 incudes the semiconductor device groups 31 and 32, and the inverter unit 202 includes the semiconductor device groups 41 to 43. The semiconductor device groups 31 and 32 are attached to a heat receiving plate disposed to a side of the converter unit 201 facing the ground, and the semiconductor device groups 41 to 43 are attached to a heat receiving plate disposed to a side of the inverter unit 202 facing the ground, so that heat generated in the semiconductor device groups 31 and 32 and the semiconductor device groups 41 to 43 is conducted to the heat receiving plates.

Radiation fins 300, each of which has a comb-shaped section when viewed from a direction indicated by the arrow "a" in FIG. 3, are disposed to a surface of the heat receiving plate that is opposite to the surface on which the semiconductor device groups are attached, i.e., the radiation fins are attached to the surface facing the ground. The heat conducted to the heat receiving plates is further conducted to the radiation fins 300, and released to the air using wind caused by the railroad car when it is running. The semiconductor device groups 31 and 32 and the semiconductor device groups 41 to 43 are cooled in this manner.

Next, the arrangement in which the radiation fins 300 are attached to the converter unit 201 and the inverter unit 202 will be described with reference to FIG. 4.

FIG. 4 shows the converter unit 201, the inverter unit 202, and four radiation fins 300 fixed to the heat receiving plate of each of the converter unit 201 and the inverter unit 202, viewed from the ground side. The arrow X indicates the directions in which the railroad car moves, as has been described above. The hatched portions of each radiation fin 300 indicate protruded portions of the cooling fin 300 having a comb-shaped section as exemplarily shown in FIG. 3, and on the other hand, the portions that are not hatched indicate recessed portions of the cooling fin 300.

As shown in FIG. 4, the converter unit 201 and the inverter unit 202 are disposed in the housing 200 so as to be adjacent to each other in the moving directions X. As a result, the radiation fins 300 attached to the heat receiving plate are closely attached.

It is assumed that the two radiation fins 300 that face each other when attached to the converter unit 201 and the inverter unit 202 are radiation fin 300C and radiation fin 300I. If attention is paid to one of the protruded portions of the radiation fin 300C, it is disposed to be aligned to one of the protruded portions of the radiation fin 300I, as indicated by broken lines 400 in FIG. 4.

The positions of the converter unit 201 and the inverter unit 202 when they are installed in the railroad car, and the positions of radiation fins 300 when they are attached to each of the converter unit 201 and the inverter unit 202 have been described with reference to FIGs. 1 to 4. The advantages of these positions will be described below.

The converter unit 201 and the inverter unit 202 have conventionally disposed so as to be adjacent to each other in a direction perpendicular to the moving direction of the railroad car.

The converter 30 and the inverter 40 generally have different loss characteristics in accordance with the running speed. Therefore, the amount of heat generated in the lateral directions Y of the railroad car becomes imbalanced.

Thus, the conventional arrangement of the converter unit 201 and the inverter unit 202 has a converter unit 201 side surface and an inverter unit 202 side surface for receiving the traveling wind. This makes it difficult for both the converter unit 201 and the inverter unit 202 to fully use the traveling wind.

In contrast, the arrangement in which the converter unit 201 and the inverter unit 202 are disposed to be adjacent to each other in the directions X along which the railroad car runs as shown in FIG. 2 may broaden the surfaces of the converter unit 201 and the inverter unit 202 for receiving the traveling wind. Therefore, the cooling efficiency may be improved.

Furthermore, since the cooling fins 300 attached to each of the converter unit 201 and the inverter unit 202 are disposed such that a recessed portion of a cooling fin 300 of the converter unit 201 is aligned with a recessed portion of the inverter unit 202, and a protruded portion of the converter unit 201 is aligned with a protruded portion of the inverter unit 202, as shown in FIG. 4, the traveling wind having flown through the recessed portion of the radiation fin 300 attached to one of the converter unit 201 and the inverter unit 202 may easily flow into the recessed portion of the radiation fin 300 of the other. This may also improve the cooling efficiency.

### (First Modification)

Next, a first modification of the first embodiment will be described with reference to FIG. 5.

FIG. 5 differs from FIG. 2 in the arrangement of the converter unit 201, the inverter unit 202, the control unit 203, and the switch and sensor unit 204. Specifically, the converter unit 201 is disposed near one of the side surfaces of the railroad car in the lateral directions Y, and the inverter unit 202 is disposed near the other of the side surfaces. As a result of this arrangement of the converter unit 201 and the inverter unit 202, the control unit 203 and the switch and sensor unit 204 are disposed near opposite side surfaces of the railroad car in the lateral directions Y.

Also in this case, in which the converter unit 201 and the inverter unit 202 are disposed near opposite side surfaces of the railroad car in the lateral directions Y, the surfaces for receiving the traveling wind may be broad, like the arrangement shown in FIG. 2. On the other hand, if the converter unit 201 and the inverter unit 202 are disposed near opposite side surfaces of the railroad car in the lateral directions Y as shown in FIG. 5, not all of the radiation fins 300 attached to the converter unit 201 may face the radiation fins 300 attached to the inverter unit 202. In this case, the cooling efficiency may be improved as described in the descriptions of the first embodiment by aligning the recessed portions and the protruded portions of the radiation fins 300 that face each other.

Furthermore, in FIG. 5, the control unit 203 and the switch and sensor unit 204 are also disposed near opposite side surfaces of the railroad car in the lateral directions Y. Generally, the control unit 203 may be weak against heat, and the contactors 71 to 74 included in the switch and sensor unit 204 may act as heat sources. Therefore, the influence of heat to the control unit 203 may be reduced by disposing them in separate locations.

### (Second Modification)

Next, a second modification of the first embodiment will be described with reference to FIGs. 6 and 7.

FIG. 6 shows a cooling fin 301 obtained by changing the structure of the cooling fin 300 shown in FIG. 3. When the structure is viewed along the arrow "a," the height Z₂ of the comb shape on the back side is shorter than the height Z₁ of the comb shape on the front side. When the cooling fins 301 having this structure are attached to the converter unit 201 and the inverter unit 202, the surfaces of the cooling fins 301 having the height Z₂ are disposed to face each other as shown in FIG. 7.

As a result of this arrangement of the cooling fins 301, a space is formed between the converter unit 201 and the inverter unit 202, and the traveling wind caused by the railroad car when it is running is drawn into the space between the converter unit 201 and the inverter unit 202. Therefore, the traveling wind is more likely to hit the cooling fins 301 of the converter unit 201 or the inverter unit 202 that is on the downstream side in the moving direction of the railroad car. This improves the cooling efficiency.

In the case where the cooling fins 301 having this structure are used, the recessed portions and the protruded portions of the facing radiation fins 301 are preferably aligned as in the case of the first embodiment.

### (Second Embodiment)

Hereinafter, a second embodiment will be described with reference to FIG. 8. The second embodiment is characterized by the arrangement of semiconductor switching devices 701 to 704 and clamping diodes 705 and 706 included in the converter 30. The arrangement of the converter unit 201, the inverter unit 202, the control unit 203, and the switch and sensor unit 204, and the arrangement and the structure of the cooling fins 300 and the cooling fins 301 may be the same as those of the first embodiment and the first modification and the second modification of the first embodiment.

FIG. 8 shows the arrangement of semiconductor devices 701 to 706 included in one phase (U phase 31) of the converter 30 included in the converter unit 201 and the arrangement of a laminated conductor 710. A semiconductor switching device (Q1) 701, a semiconductor switching device (Q2) 702, a semiconductor switching device (Q3) 703, and a semiconductor switching device (Q4) 704 are connected by the laminated conductor 710 to form a U shape. Furthermore, a clamping diode (cd) 705 is connected between the semiconductor switching device (Q1) 701 and the semiconductor switching device (Q2) 702, and a clamping diode (cd) 706 is connected between the semiconductor switching device (Q3) 703 and the semiconductor switching device (Q4) 704. Moreover, the clamping diode (cd) 705 and the clamping diode (cd) 706 are connected to each other with another laminated conductor 711.

The semiconductor switching device (Q1) 701, the semiconductor switching device (Q2) 702, the semiconductor switching device (Q3) 703, and the semiconductor switching device (Q4) 704 are connected in series in this order. The semiconductor switching device (Q1) 701 and the semiconductor switching device (Q2) 702 are disposed between the positive electrode side wiring line P and the neutral point wiring line C shown in FIG. 1, and the semiconductor switching device (Q3) 703 and the semiconductor switching device (Q4) 704 are disposed between the neutral point wiring line C and the negative electrode side wiring line N. Furthermore, the clamping diode (cd) 705 and the clamping diode (cd) 706 are connected in series with each other, and in parallel with the semiconductor switching device (Q2) 702 and the semiconductor switching device (Q3) 703.

As shown in FIG. 8, the semiconductor switching device (Q1) 701 and the semiconductor switching device (Q2) 702 are arranged to be adjacent to each other, and the semiconductor switching device (Q1) 703 and the semiconductor switching device (Q2) 704 are arranged to be adjacent to each other in the running directions X of the railroad car. While the railroad car is being powered, the loss of the semiconductor switching device (Q2) 702 and the semiconductor switching device (Q3) 703 on the neutral point wiring line C side is great, and the amount of heat generated as a result is great. By arranging these two semiconductor switching devices to be adjacent to each other in a direction that is perpendicular to the running directions X of the railroad car, the heat generated by the four semiconductor switching devices (Q1 to Q4) 701 to 704 may become substantially uniform when conducted to the cooling fins 300 (or 301). Therefore, heat dissipation may be performed in a balanced manner.

Although FIG. 8 only shows the arrangement of the U-phase semiconductor devices of the converter 30, the V-phase semiconductor devices are arranged in the same manner.

The U-phase, V-phase, and W-phase semiconductor devices included in the inverter 40 are also arranged in the same manner as those of the converter 30 shown in FIG. 8. As is opposite to the converter 30, while the railroad car is being powered, the loss increases in the semiconductor switching device Q1 (701) that is near the positive electrode side wiring line P and the semiconductor switching device Q4 (704) that is near the negative electrode side wiring line N. However, the effect has no difference, and the heat generated in the four semiconductor switching devices (Q1 to Q4) 701 to 704 is conducted to the cooling fins 300 (or 301) in a substantially uniform manner.

### [Description of Reference Numerals]

- 10: control unit
- 20: transformer
- 30: converter
- 40: inverter
- 50: circuit breaker
- 61, 62: charge resistor
- 71, 72, 73, 74: contactor
- 81, 82: voltage-dividing capacitor
- 90: current detector
- 100: car control device
- 201: converter unit
- 202: inverter unit
- 203: control unit
- 204: switch and sensor unit
- 300, 301: radiation fin

## Claims

1. A power conversion device comprising:
a converter unit including a first heat receiving plate, and a plurality of semiconductor switching devices attached to the first heat receiving plate, the converter unit being configured to convert AC power to DC power;
an inverter unit disposed to be adjacent to the converter unit in a railroad car running direction and including a second heat receiving plate, and a plurality of semiconductor switching devices attached to the second heat receiving plate, the inverter unit being configured to convert the DC power outputted from the converter unit to AC power;
a plurality of first radiation fins attached to a surface of the first heat receiving plate opposite to a surface on which the semiconductor switching devices are attached; and
a plurality of second radiation fins attached to a surface of the second heat receiving plate opposite to a surface on which the semiconductor switching devices are attached,
the first radiation fins and the second radiation fins facing one another being attached to the first heat receiving plate and the second heat receiving plate so that recessed portions of the first radiation fins and recessed portions of the second radiation fins are aligned with one another.

2. The power conversion device of claim 1, wherein the converter unit and the inverter unit each include a plurality of power conversion phases including series-connected four semiconductor switching devices, of which two semiconductor switching devices that are adjacent to each other with at least a neutral point wiring line being disposed therebetween are arranged in a direction perpendicular to the railroad car running direction.

3. A car control device comprising:
a converter unit including a first heat receiving plate, and a plurality of semiconductor switching devices attached to the first heat receiving plate, the converter unit being configured to convert AC power supplied from an overhead electric line via a pantograph and a circuit breaker to DC power;
an inverter unit disposed to be adjacent to the converter unit in a railroad car running direction and including a second heat receiving plate, and a plurality of semiconductor switching devices attached to the second heat receiving plate, the inverter unit being configured to convert the DC power outputted from the converter unit to three-phase AC power for driving a motor;
a control unit configured to output a gate command to the converter unit and the inverter unit;
a plurality of first radiation fins attached to a surface of the first heat receiving plate opposite to a surface on which the semiconductor switching devices are attached; and
a plurality of second radiation fins attached to a surface of the second heat receiving plate opposite to a surface on which the semiconductor switching devices are attached,
the first radiation fins and the second radiation fins facing one another being attached to the first heat receiving plate and the second heat receiving plate so that recessed portions of the first radiation fins and recessed portions of the second radiation fins are aligned with one another.

4. The car control device of claim 3, wherein the converter unit and the inverter unit each include a plurality of power conversion phases including series-connected four semiconductor switching devices, of which two semiconductor switching devices that are adjacent to each other with at least a neutral point wiring line being disposed therebetween are arranged in a direction perpendicular to the railroad car running direction.
